# EUROPEAN PATENT APPLICATION

(11) **EP 4 788 110 A1**
(43) Date of publication of application: **05.08.2026**
(21) Application number: 23954351.5
(22) Date of filing: 29.09.2023
(51) Int. Cl.: H10N 60/12

(54) **QUANTUM DEVICE**

(71) Applicant: FUJITSU LIMITED, Kawasaki-shi, Kanagawa 211-8588 (JP)
(72) Inventor: SAIDA, Daisuke, Kawasaki-shi, Kanagawa 211-8588 (JP)
(74) Representative: Haseltine Lake Kempner LLP
(86) International application number: PCT/JP2023/035658
(87) International publication number: WO 2025/069382

(57) **Abstract**

A quantum device (1) includes one or more qubits (10), wherein each qubit of the one or more qubits includes a first conductor (11), a second conductor (12) surrounding the first conductor in a plan view, and a Josephson junction device (13) connected between the first conductor and the second conductor, the first conductor has a first surface (511) facing the second conductor, the second conductor has a second surface (521) facing the first conductor, and the first surface, or the second surface, or both the first and second surfaces have a shape including at least two points (516, 517, 528, 529) having mutually different curvatures in the plan view. The quantum device can be used for quantum computing, for example.

## Description

### TECHNICAL FIELD

The present disclosure relates to quantum devices.

### BACKGROUND ART

There is a proposed quantum device including a qubit configured by connecting a Josephson junction device between two conductors.

### PRIOR ART DOCUMENTS

### PATENT DOCUMENTS

Patent Document 1: U.S. Patent Application Publication No. 2020/0265334
Patent Document 2: U.S. Patent Application Publication No. 2022/0376161
Patent Document 3: Japanese Laid-Open Patent Publication No. 2020-61447
Patent Document 4: U.S. Patent Application Publication No. 2021/0343785

### DISCLOSURE OF THE INVENTION

### PROBLEM TO BE SOLVED BY THE INVENTION

Recently, there are increasing demands for accurately manipulating a state of the qubit including the Josephson junction device using a waveform of an input electromagnetic field.

One object of the present disclosure is to provide a quantum device that can improve an electromagnetic field confinement efficiency within a qubit, and can be appropriately manipulated by a waveform of an input electromagnetic field.

### MEANS OF SOLVING THE PROBLEM

According to an aspect of the present disclosure, a quantum device includes one or more qubits, wherein each qubit of the one or more qubits includes a first conductor; a second conductor surrounding the first conductor in a plan view; and a Josephson junction device connected between the first conductor and the second conductor, the first conductor has a first surface facing the second conductor, the second conductor has a second surface facing the first conductor, and the first surface, or the second surface, or both the first and second surfaces have a shape including at least two points having mutually different curvatures in the plan view.

### EFFECTS OF THE INVENTION

According to the present disclosed technique, it is possible to improve the electromagnetic field confinement efficiency within the qubit, and appropriately manipulate the qubit device by the waveform of the input electromagnetic field.

### BRIEF DESCRIPTION OF THE DRAWINGS

[FIG. 1] FIG. 1 is a plan view illustrating a quantum device according to a first embodiment.
[FIG. 2] FIG. 2 is a plan view illustrating a qubit.
[FIG. 3] FIG. 3 is a diagram illustrating a first structure.
[FIG. 4] FIG. 4 is a diagram illustrating a second structure.
[FIG. 5] FIG. 5 is a diagram illustrating a third structure.
[FIG. 6] FIG. 6 is a diagram illustrating simulation results.
[FIG. 7] FIG. 7 is a schematic diagram illustrating the quantum device according to a second embodiment.
[FIG. 8] FIG. 8 is a schematic diagram illustrating the quantum device according to a third embodiment.
[FIG. 9] FIG. 9 is a schematic diagram illustrating the quantum device according to a fourth embodiment.
[FIG. 10] FIG. 10 is a schematic diagram illustrating the quantum device according to a fifth embodiment.
[FIG. 11] FIG. 11 is a diagram illustrating an example of a usage of the quantum device.

### MODE OF CARRYING OUT THE INVENTION

Hereinafter, embodiments of the present disclosure will be specifically described with reference to the accompanying drawings. In the present specification and drawings, constituent elements having substantially the same functional configuration are designated by the same reference numerals, and a redundant description thereof may be omitted. In the present disclosure, a plan view of an object refers to a view of the object viewed in a direction perpendicular to a principal surface of a substrate, and a planar shape of the object refers to a shape of the object in the plan view viewed in the direction perpendicular to the principal surface of the substrate.

### (First Embodiment)

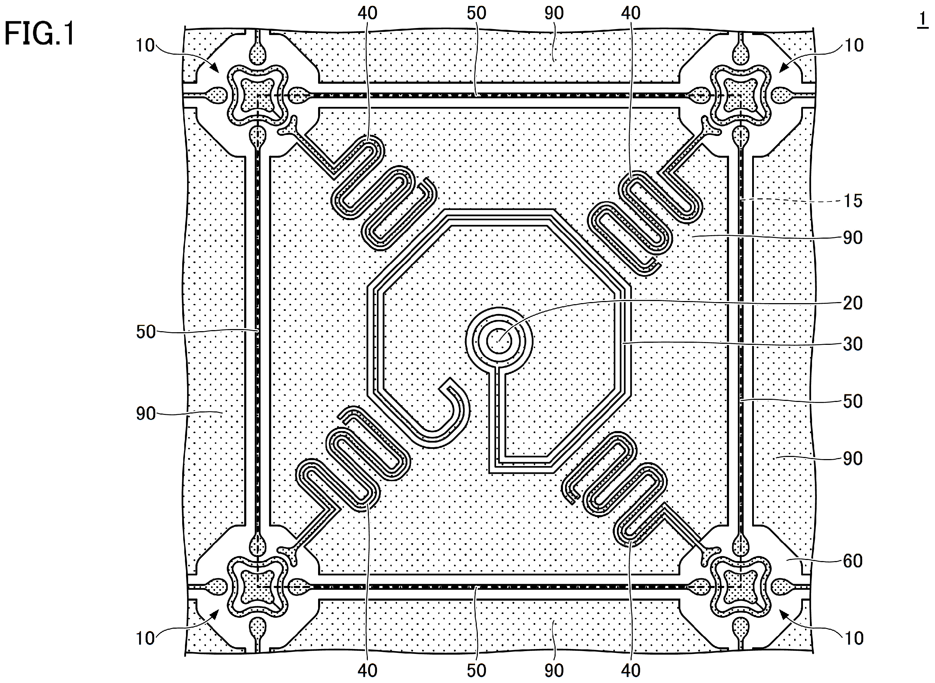

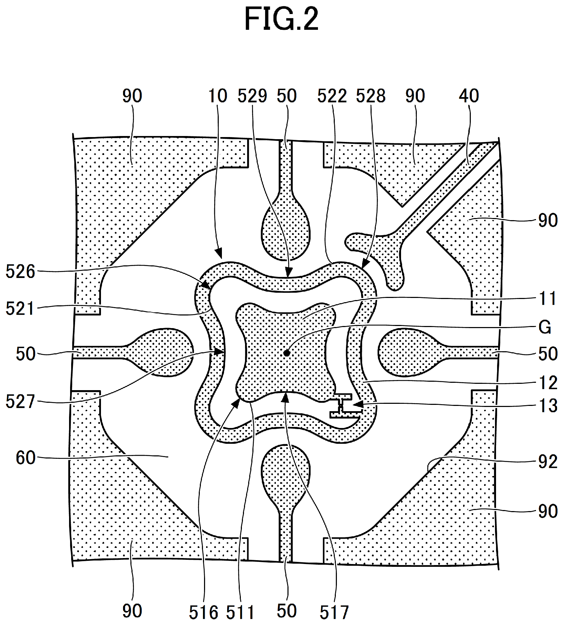

First, a first embodiment will be described. The first embodiment relates to a quantum device. FIG. 1 is a plan view illustrating the quantum device according to a first embodiment. FIG. 2 is a plan view illustrating a qubit.

As illustrated in FIG. 1, a quantum device 1 according to the first embodiment includes a substrate 60, a plurality of qubits 10, a readout port 20, a filter 30, a plurality of resonators 40 (readout resonators), a plurality of interconnect conductors 50, and a ground conductor 90. The qubits 10, the readout port 20, the filter 30, the resonators 40, the interconnect conductors 50, and the ground conductor 90 are provided on a principal surface of the substrate 60. The qubits 10, the readout port 20, the filter 30, the resonators 40, the interconnect conductors 50, and the ground conductor 90 include a metal film, for example, and are formed as a thin film.

The qubit 10 is a superconducting qubit, and has a resonant frequency from 2 GHz to 10 GHz, for example. The qubits 10 are arranged in a square lattice.

As illustrated in FIG. 2, the qubit 10 includes an inner conductor 11, an outer conductor 12, and a Josephson junction device 13. In the plan view, the outer conductor 12 surrounds the inner conductor 11. The inner conductor 11 and the outer conductor 12 are electrically insulated from each other. The Josephson junction device 13 is provided between the inner conductor 11 and the outer conductor 12, and is connected between the inner conductor 11 and the outer conductor 12. In the present embodiment, an electrical control signal is supplied to the inner conductor 11. The inner conductor 11 is an example of a first conductor, and the outer conductor 12 is an example of a second conductor.

The inner conductor 11 has a side surface 511 facing the outer conductor 12. The outer conductor 12 has an inner side surface 521 facing the inner conductor 11, and an outer side surface 522 opposite to the inner side surface 521. The side surface 511, the inner side surface 521, and the outer side surface 522 are curved surfaces containing curves in the plan view. In the plan view, each of the side surface 511, the inner side surface 521, and the outer side surface 522 has a shape including at least two points having different curvatures. That is, the planar shapes of the side surface 511, the inner side surface 521, and the outer side surface 522 are not circular shapes. The side surface 511 is an example of a first surface, the inner side surface 521 is an example of a second surface, and the outer side surface 522 is an example of a third surface.

For example, in the plan view, the side surface 511 includes convex protrusions 516 that protrude in a direction away from a center of gravity G of the inner conductor 11, and concave recesses 517 that are recessed in a direction toward the center of gravity G. The side surface 511 contains a meandering curve in the plan view. The shape of the side surface 511 may be fourfold rotationally symmetric in the plan view. In a polar coordinate system having the center of gravity G as the origin, the convex protrusions 516 may be arranged at a period of 90 degrees along a circumferential direction, and the concave recess 517 may be arranged between two adjacent convex protrusions 516.

For example, in the plan view, the inner side surface 521 includes convex protrusions 526 that protrude in a direction away from the center of gravity G, and concave recesses 527 that are recessed in a direction toward the center of gravity G. The inner side surface 521 contains a meandering curve in the plan view. The shape of the inner side surface 521 may be fourfold rotationally symmetric in the plan view. In the polar coordinate system having the center of gravity G as the origin, the convex protrusions 526 may be arranged at a period of 90 degrees along the circumferential direction, and the concave recess 527 may be arranged between two adjacent convex protrusions 526.

In the polar coordinate system having the center of gravity G as the origin, it is preferable that a positive or negative sign of a rate of change in curvature of the side surface 511 and a positive or negative sign of a rate of change in curvature of the inner side surface 521 at identical deflection angles (inclination angles, polar angles) match each other. That is, it is preferable that the inner side surface 521 also protrudes at portions where the side surface 511 protrudes along the circumferential direction, and the inner side surface 521 is also recessed at portions where the side surface 511 is recessed along the circumferential direction. It is particularly preferable that the side surface 511 and the inner side surface 521 are parallel to each other. That is, it is particularly preferable that the shape of the side surface 511 and the shape of the inner side surface 521 are similar to each other in the plan view.

For example, in the plan view, the outer side surface 522 includes convex protrusions 528 that protrude in a direction away from the center of gravity G, and concave recesses 529 that are recessed in a direction toward the center of gravity G. The outer side surface 522 contains a meandering curve in the plan view. The shape of the outer side surface 522 may be fourfold rotationally symmetric in the plan view. In the polar coordinate system having the center of gravity G as the origin, the convex protrusions 528 may be arranged at a period of 90 degrees along the circumferential direction, and the concave recess 529 may be arranged between two adjacent convex protrusions 528.

In the polar coordinate system having the center of gravity G as the origin, the positive or negative sign of the rate of change in curvature of the inner side surface 521 and the positive or negative sign of the rate of change in curvature of the outer side surface 522 at identical deflection angles (inclination angles, polar angles) may match each other. That is, the outer side surface 522 may also protrude at portions where the inner side surface 521 protrudes along the circumferential direction, and the outer side surface 522 may also be recessed at portions where the inner side surface 521 are recessed along the circumferential direction. The inner side surface 521 and the outer side surface 522 may be parallel to each other. That is, the shape of the inner side surface 521 and the shape of the outer side surface 522 may be similar to each other in the plan view.

The ground conductor 90 has a ground potential. In a periphery of the qubit 10, the ground conductor 90 is provided on the outer side of the outer conductor 12 in the plan view, and surrounds the inner conductor 11 and the outer conductor 12. The outer conductor 12 and the ground conductor 90 are electrically insulated from each other. The ground conductor 90 has a side surface 92 facing the outer conductor 12. The side surface 92 is not parallel to the outer side surface 522. The side surface 92 is an example of a fourth surface.

The readout port 20 is located at a center of a square 15 formed by the four qubits 10 in the plan view. The filter 30 is capacitively coupled to one readout port 20 and is coupled to four resonators 40. For example, the filter 30 is capacitively coupled to four resonators 40. The four resonators 40 are capacitively coupled to the qubits 10 so that one resonator 40 is capacitively coupled to one qubit 10. The four resonators 40 may have different resonant frequencies. For example, the resonant frequency of one resonator 40 may be 10.1 GHz, the resonant frequency of another resonator 40 may be 10.2 GHz, the resonant frequency of still another resonator 40 may be 10.3 GHz, and the resonant frequency of the remaining resonator 40 may be 10.4 GHz. The interconnect conductor 50 is provided on each side of the square 15 in the plan view and is capacitively coupled to two qubits 10. The interconnect conductors 50 face the outer conductor 12 and are capacitively coupled to the outer conductor 12. The interconnect conductors 50 faces the concave recesses 529 of the outer conductor 12. The two qubits 10 are capacitively coupled to each other via the interconnect conductor 50. The ground conductor 90 is provided in peripheries of the readout port 20, the filter 30, the resonators 40, and the interconnect conductors 50.

In the quantum device 1, both the side surface 511 and the inner side surface 521 have a shape including at least two points having different curvatures in the plan view. For this reason, compared to a case where the planar shapes of the side surface 511 and the inner side surface 521 are circular, mutually opposing areas of the side surface 511 and the inner side surface 521 is large, and electric field lines converge without spreading between the inner conductor 11 and the outer conductor 12. Accordingly, a high Q value can be obtained, and it is possible to improve an electromagnetic field confinement efficiency within the qubit 10.

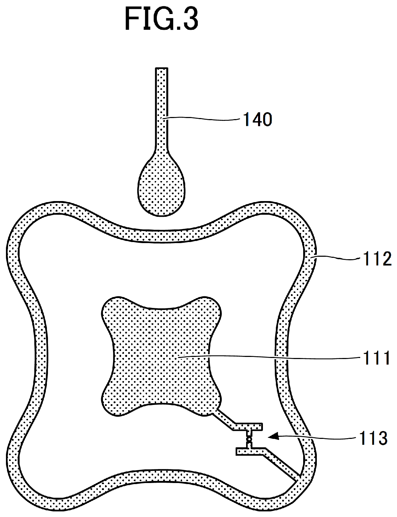

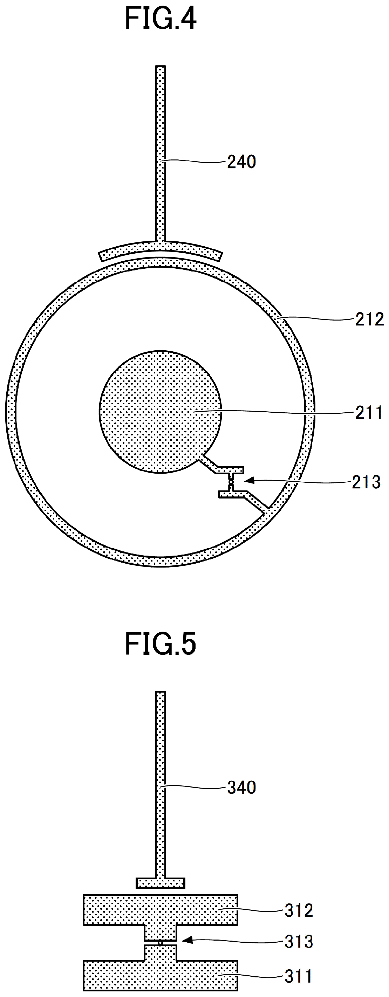

Next, simulation results of the Q value for reference examples will be described. FIG. 3 is a diagram illustrating a first structure modeled after the first embodiment. FIG. 4 is a diagram illustrating a second structure according to the first reference example. FIG. 5 is a diagram illustrating a third structure according to a second reference example.

As illustrated in FIG. 3, a first structure A includes an inner conductor 111, an outer conductor 112, and a Josephson junction device 113 that are modeled after the inner conductor 11, the outer conductor 12, and the Josephson junction device 13 of the quantum device 1. The first structure A includes a resonator 140 capacitively coupled to the outer conductor 112. Although only a portion of the resonator 140 is illustrated in FIG. 3, the resonator 140 may have the same structure as the resonator 40 illustrated in FIG. 1. The shape of the resonator 140 at a capacitive coupling part between the resonator 140 and the qubit 10 may be a convex shape or a concave shape toward the qubit 10.

As illustrated in FIG. 4, a second structure B includes an inner conductor 211, an outer conductor 212, and a Josephson junction device 213. A side surface of the inner conductor 211 facing the outer conductor 212, an inner side surface of the outer conductor 212 facing the inner conductor 211, and an outer side surface of the outer conductor 212 on the opposite side from the inner side surface thereof have circular planar shapes. The Josephson junction device 213 is connected between the inner conductor 211 and the outer conductor 212. The second structure B includes a resonator 240 capacitively coupled to the outer conductor 212. Although only a portion of the resonator 240 is illustrated in FIG. 4, the resonator 240 may have the same structure as the resonator 40 illustrated in FIG. 1.

As illustrated in FIG. 5, a third structure C includes a first conductor 311, a second conductor 312, and a Josephson junction device 313. The first conductor 311 and the second conductor 312 are formed in linear shapes parallel to each other. A side surface of the first conductor 311 facing the second conductor 312 and a side surface of the second conductor 312 facing the first conductor 311 have linear planar shapes. The Josephson junction device 313 is connected between the first conductor 311 and the second conductor 312. The third structure C includes a resonator 340 capacitively coupled to the second conductor 312. Although only a portion of the resonator 340 is illustrated in FIG. 5, the resonator 340 may have the same structure as the resonator 40 illustrated in FIG. 1.

The qubits of the first structure A, the second structure B, and the third structure C have approximately the same size in the plan view, and have the resonant frequency of 8 GHz, respectively.

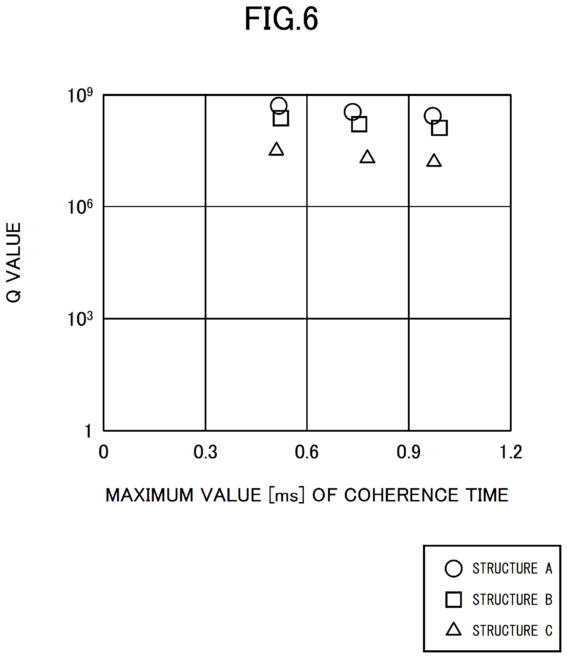

Further, for each of the first structure A, the second structure B, and the third structure C, a relationship between a maximum value of several coherence times and the Q value was computed. Results of the computation are illustrated in FIG. 6. FIG. 6 is a diagram illustrating simulation results. As illustrated in FIG. 6, the second structure B can obtain a higher Q value than the third structure C. This is because the electric field lines in the third structure C also spread to the outer side of the mutually opposing portions of the first conductor 311 and the second conductor 312. In addition, the first structure A can obtain a higher Q value than the second structure B. This is because the mutually opposing area between the inner conductor 111 and the outer conductor 112 in the first structure A is larger than the mutually opposing area between the inner conductor 211 and the outer conductor 212 in the second structure B, and the electric field lines in the first structure A converge without spreading. In other words, a distance over which the inner conductor 111 and the outer conductor 112 extend facing each other in the plan view is longer than a distance over which the inner conductor 211 and the outer conductor 212 extend facing each other, and the electric field lines in the first structure A converge without spreading.

Moreover, in the quantum device 1, the side surface 92 of the ground conductor 90 is not parallel to the outer side surface 522 of the outer conductor 12, and a distance from the ground conductor 90 is particularly large at the portions provided with the concave recesses 517, 527, and 529. For this reason, a capacitance between the outer conductor 12 and the ground conductor 90 can be kept low. Accordingly, even when the capacitance between the outer conductor 12 and the interconnect conductor 50 is small, it is possible to obtain a capacitive coupling that can be identified between the two qubits 10 via the interconnect conductor 50. Thus, even in a case where the qubit 10 is further capacitively coupled to another qubit 10, crosstalk can be suppressed. A capacitance of the outer conductor 12 with respect to the ground potential is 10 fF or greater and 180 fF or less, for example.

In addition, in a case where the resonant frequencies differ among the four resonators 40, the states of the four qubits 10 can be read out simultaneously by inputting a 10 GHz signal to the readout port 20. That is, the states of the four qubits 10 can be read simultaneously by performing frequency separation on the readout signal.

### (Second Embodiment)

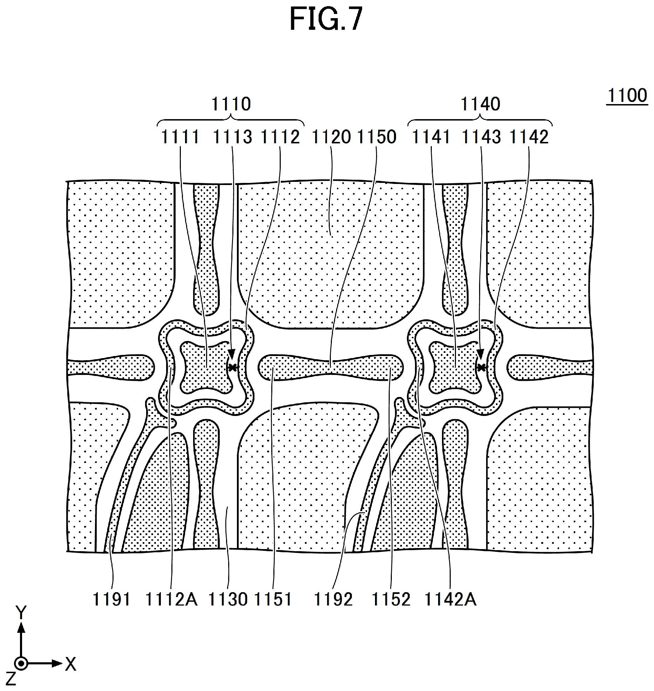

Next, a second embodiment will be described. The second embodiment relates to a quantum device. FIG. 7 is a schematic diagram illustrating the quantum device according to the second embodiment. In the following description, an XYZ orthogonal coordinate system is used, and when viewed from an arbitrary point, a +Z side may be referred to as upward, upper side, or above, and a -Z side may be referred to as a downward, lower side, or below. However, the coordinate system is defined for the sake of convenience of description, and does not limit the orientation of the quantum device.

As illustrated in FIG. 7, a quantum device 1100 according to the second embodiment includes a qubit 1110, a qubit 1140, a ground conductor 1120, an interconnect conductor 1150, a readout conductor 1191, a readout conductor 1192, and a substrate 1130. The qubit 1110 includes an inner conductor 1111, an outer conductor 1112, and a Josephson junction device 1113. The qubit 1140 includes an inner conductor 1141, an outer conductor 1142, and a Josephson junction device 1143. The inner conductor 1111, the inner conductor 1141, the outer conductor 1112, the outer conductor 1142, the Josephson junction device 1113, the Josephson junction device 1143, the interconnect conductor 1150, the readout conductor 1191, the readout conductor 1192, and the ground conductor 1120 are provided on a principal surface of the substrate 1130. In the plan view perpendicular to the principal surface of the substrate 1130, the outer conductor 1112 surrounds the inner conductor 1111, and the outer conductor 1142 surrounds the inner conductor 1141. The inner conductor 1111 and the outer conductor 1112 are electrically insulated from each other, and the inner conductor 1141 and the outer conductor 1142 are electrically insulated from each other. In the plan view, the inner conductors 1111 and 1141 have a shape that is recessed along the X axis, recessed along the Y axis, and protrudes in four directions inclined at 45 degrees from the X axis and the Y axis. In the plan view, the outer conductors 1112 and 1142 have a shape that follows outer edges of the inner conductors 1111 and 1141, that is, a shape that is recessed along the X axis, recessed along the Y axis, and protrudes in four directions inclined at 45 degrees from the X axis and the Y axis. The inner conductors 1111 and 1141 are examples of a first conductor, and the outer conductors 1112 and 1142 are examples of a second conductor. The ground conductor 1120 has a ground potential.

The interconnect conductor 1150 is provided between the qubit 1110 and the qubit 1140. The interconnect conductor 1150 includes a convex protrusion 1151 protruding toward the outer conductor 1112, and a convex protrusion 1152 protruding toward the outer conductor 1142. The outer conductor 1112 of the qubit 1110 includes concave recesses 1112A that are recessed away from the convex protrusion 1151, and the outer conductor 1142 of the qubit 1140 includes concave recesses 1142A that are recessed away from the convex protrusion 1152. The interconnect conductor 1150 is capacitively coupled to the outer conductors 1112 and 1142. The outer conductors 1112 and 1142 are capacitively coupled to each other via the interconnect conductor 1150.

In the present embodiment, an electrical control signal is supplied to the inner conductors 1111 and 1141. The readout conductor 1191 is capacitively coupled to the outer conductor 1112, and the readout conductor 1192 is capacitively coupled to the outer conductor 1142. The state of the qubit 1110 is read out to the outside via the readout conductor 1191, and the state of the qubit 1140 is read out to the outside via the readout conductor 1192.

The ground conductor 1120 surrounds the qubit 1110, the qubit 1140, the interconnect conductor 1150, the readout conductor 1191, and the readout conductor 1192. The quantum device 1100 may include another qubit capacitively coupled to the qubit 1110, or another qubit capacitively coupled to the qubit 1140, or an interconnect conductor capacitively coupling these other qubits capacitively coupled to the qubit 1110 and the qubit 1140, respectively. In this case, these other qubits capacitively coupled to the qubit 1110 and the qubit 1140, respectively, and the interconnect conductor capacitively coupling these other qubits capacitively coupled to the qubit 1110 and the qubit 1140, respectively, are also surrounded by the ground conductor 1120.

For example, a capacitance of the qubit 1110 with respect to the ground and a capacitance of the qubit 1140 with respect to the ground are 10 fF or greater and 180 fF or less. A capacitance of a capacitor including the outer conductor 1112 and the ground conductor 1120 and a capacitance of a capacitor including the outer conductor 1142 and the ground conductor 1120 may be 10 fF or greater and 180 fF or less.

According to the second embodiment, an excellent electromagnetic field confinement effect can be obtained within the qubits 1110 and 1140. In addition, a large internal current can be obtained in the qubits 1110 and 1140. Further, even in the case where the qubit 1110 or 1140 is further capacitively coupled to another qubit, crosstalk can be suppressed. In FIG. 7, the readout conductor 1191 is arranged on the lower left side with respect to the qubit 1110, but the readout conductor 1191 is not limited to such an arrangement. The quantum device illustrated in FIG. 1 may be configured by using two qubits in addition to the qubit 1110 and the qubit 1140. In this case, if the qubit 1110 and the qubit 1140 correspond to the two qubits 10 illustrated on the upper side in FIG. 1, the readout conductor 1191 is arranged on the lower right side with respect to the qubit 1110 in FIG. 7.

### (Third Embodiment)

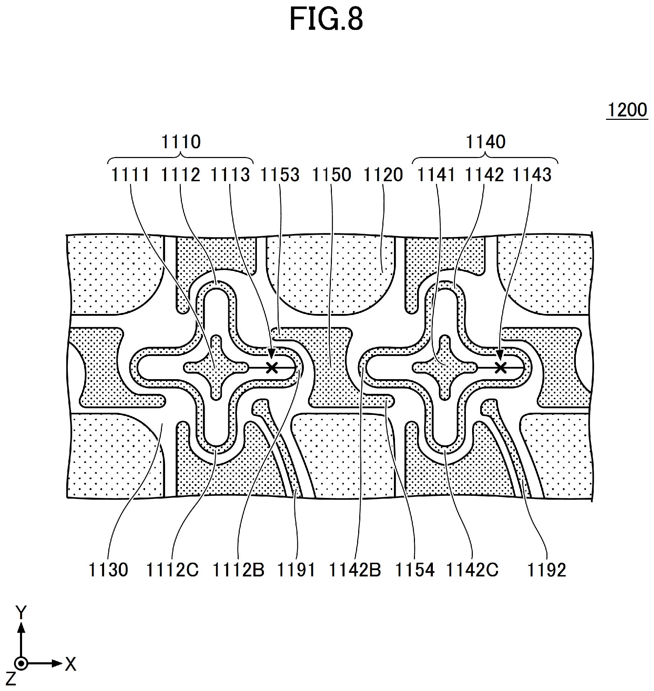

Next, a third embodiment will be described. The third embodiment differs from the second embodiment mainly in the configuration of the capacitive coupling between the qubits. FIG. 8 is a schematic diagram illustrating the quantum device according to the third embodiment.

As illustrated in FIG. 8, in a quantum device 1200 according to the third embodiment, the inner conductors 1111 and 1141 have a shape that protrudes along the X axis, protrudes along the Y axis, and is recessed in four directions inclined by 45 degrees from the X axis and the Y axis in the plan view. In the plan view, the outer conductors 1112 and 1142 have shapes that follow outer edges of the inner conductors 1111 and 1141, respectively. That is, in the plan view, the outer conductor 1112 includes two convex protrusions 1112B protruding along the X-axis and two convex protrusions 1112C protruding along the Y-axis, and the outer conductor 1142 includes two convex protrusions 1142B protruding along the X-axis and two convex protrusions 1142C protruding along the Y-axis.

The interconnect conductor 1150 includes a protrusion 1153 that is located on the +Y side of the +X side convex protrusion 1112B and is capacitively coupled to the +X side convex protrusion 1112B, and a protrusion 1154 that is located on the -Y side of the -X side convex protrusion 1142B and is capacitively coupled to the -X side convex protrusion 1142B.

Otherwise, the configuration of the third embodiment is the same as that of the second embodiment. The third embodiment can also obtain the same effects as those obtainable in the second embodiment.

### (Fourth Embodiment)

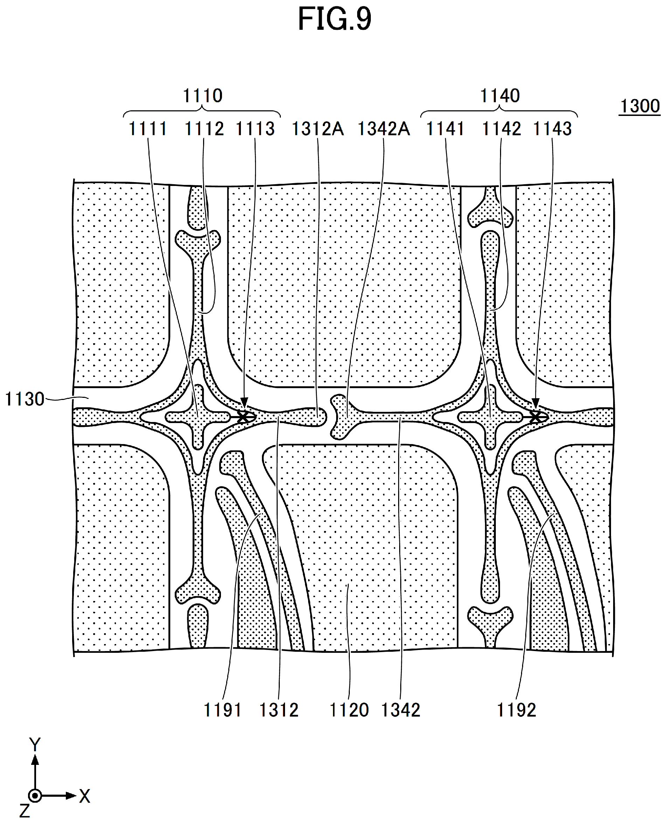

Next, a fourth embodiment will be described. The fourth embodiment differs from the third embodiment mainly in the configuration of the capacitive coupling between the qubits. FIG. 9 is a schematic diagram illustrating the quantum device according to the fourth embodiment.

As illustrated in FIG. 9, a quantum device 1300 according to the fourth embodiment does not include the interconnect conductor 1150. The outer conductor 1112 includes an extending part 1312 extending toward the outer conductor 1142, and the outer conductor 1142 includes an extending part 1342 extending toward the outer conductor 1112. The extending part 1312 includes a convex protrusion 1312A that protrudes toward the outer conductor 1142, and the extending part 1342 includes a concave recess 1342A that is recessed in a direction away from the outer conductor 1112. The extending parts 1312 and 1342 face each other and are capacitively coupled to each other.

Otherwise the configuration of the fourth embodiment is the same as that of the third embodiment. The fourth embodiment can also obtain the same effects as those obtainable in the third embodiment.

### (Fifth Embodiment)

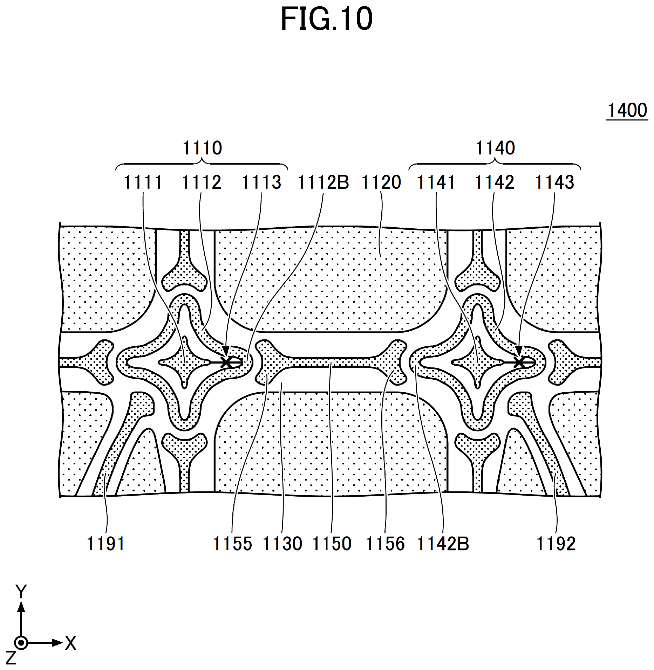

Next, a fifth embodiment will be described. The fifth embodiment differs from the third embodiment mainly in the configuration of the capacitive coupling between the qubits. FIG. 10 is a schematic diagram illustrating the quantum device according to the fifth embodiment.

As illustrated in FIG. 10, in the plan view of a quantum device 1400 according to the fifth embodiment, the interconnect conductor 1150 includes a recess 1155 that is located on the +X side of the +X side convex protrusion 1112B and capacitively coupled to the +X side convex protrusion 1112B, and a recess 1156 that is located on the -X side of the -X side convex protrusion 1142B and capacitively coupled to the -X side convex protrusion 1142B.

In addition, in the quantum device 1200, the readout conductor 1191 extends from the qubit 1110 to the +X side and the -Y side, whereas in the quantum device 1400, the readout conductor 1191 extends from the qubit 1110 to the -X side and the -Y side.

Otherwise, the configuration of the fifth embodiment is the same as that of the third embodiment. The fifth embodiment can also obtain the same effects as those obtainable in the third embodiment.

In the present disclosure, the first surface of the first conductor and the second surface of the second conductor do not need to be parallel to each other, and the shape of the first surface of the first conductor and the shape of the second surface of the second conductor do not need to be similar to each other in the plan view. In addition, in the plan view, the shape of the first surface and the shape of the second surface do not need to be fourfold rotationally symmetric, and may be twofold rotationally symmetric, threefold rotationally symmetric, or fivefold or more rotationally symmetric. The shape of the first surface and the shape of the second surface may not be rotationally symmetric in the plan view. In the polar coordinate system having the center of gravity G as the origin, the sign of the rate of change in curvature of the first surface and the sign of the rate of change in curvature of the second surface at identical deflection angles may not match each other. Moreover, as long as at least one of the first surface or the second surface has a shape including at least two points having different curvatures in the plan view, the other surface may have a circular planar shape.

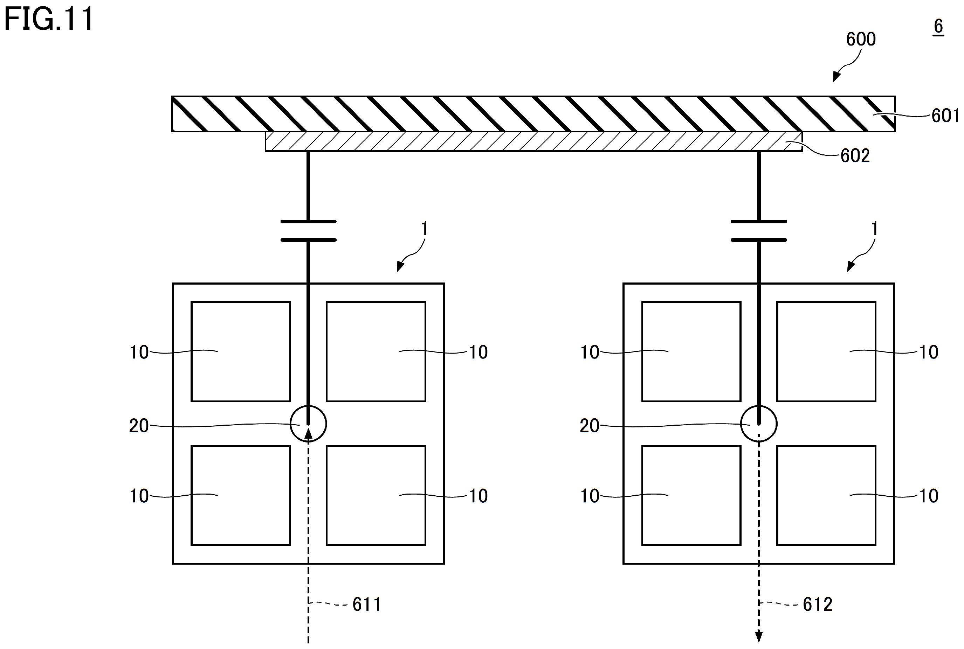

Next, an example of a usage of the quantum device 1 will be described. FIG. 11 is a diagram illustrating an example of the usage of the quantum device.

In this usage, two quantum devices 1 are used, where each quantum device 1 includes four qubits 10. In each quantum device 1, four qubits 10 are coupled to a readout port 20. Although not illustrated, each quantum device 1 includes a filter 30, a resonator 40, an interconnect conductor 50, a ground conductor 90, or the like. The two quantum devices 1 are capacitively coupled to each other via a cover chip 600. The cover chip 600 includes a substrate 601 and a resonator 602. The resonator 602 has a path length that is 1/2 the wavelength λ of a signal input to the quantum device 1 during the readout. One quantum device 1 is capacitively coupled to one end of the resonator 602, and the other quantum device 1 is capacitively coupled to the other end of the resonator 602. Among a total of eight qubits 10, the resonant frequency of the resonator 40 between qubit 10 and the readout port 20 is shifted among the eight qubits 10. In this state, the resonator 602 of each qubit 10 is coupled to the readout port 20 via a filter (for example, a Purcell filter). For example, focusing on the two qubits 10 in the upper part on the left side of FIG. 11, this corresponds to a case where the readout conductor 1191 is arranged on the -X side (the -Y side of the interconnect conductor 1150) in FIG. 7.

When a signal 611 is input to the readout port 20 of a first quantum device 1, the states of the four qubits 10 included in the first quantum device 1 are read out and input to the readout port 20 of the other, second quantum device 1 via the resonator 602. As a result, the states of the four qubits 10 included in the second quantum device 1 are also read, and a signal 612 in which the states of the eight qubits 10 are superimposed is output. The states of the eight qubits 10 can be read out simultaneously by performing frequency separation on the signal 612. In this example, eight-way multiplexing can be achieved.

In another example of the usage, the quantum device 1 may be used for multiplexing when performing readout from four qubits 10 without providing the resonator 602 functioning as a filter in the cover chip 600. In this case, the resonator 40 of each qubit 10 is arranged to couple to the filter 30 (Purcell filter) capacitively coupled to the readout port 20 as in FIG. 1. In this example, four-way multiplexing can be achieved.

The state of the qubit 10 can be manipulated by inputting a signal from a pogo pin to an electrode capacitively coupled to the inner conductor 11 via the substrate, for example. In addition, the input of the signal to the electrode capacitively coupled to the inner conductor 11 via the substrate may be performed from a bump provided on an interposer, a wiring board, or the like. The number of qubits 10 included in one quantum device 1 is not particularly limited. For example, 64 or 256 qubits 10 may be included in one quantum device 1, or 1000 or more qubits 10 may be included in one quantum device.

The quantum device according to the present disclosure can be used for quantum computing, for example.

Although the preferred embodiments or the like are described above in detail, the present disclosure is not limited to the embodiments or the like described above, and various modifications and substitutions can be made to the embodiments or the like described above without departing from the scope recited in the claims.

For example, in FIG. 7 through FIG. 10, the Josephson junction is arranged on the X-axis, but the arrangement is not limited to such a position. The Josephson junction may be arranged in a 45-degree direction from the center of gravity G to connect the inner conductor 11 and the outer conductor 12. As described above, the position where the Josephson junction is arranged is not limited to those of the embodiments or the like described above.

### DESCRIPTION OF THE REFERENCE NUMERALS

1, 1100, 1200, 1300, 1400: quantum device
10, 1110, 1140: qubit
11, 1111, 1141: inner conductor
12, 1112, 1142: outer conductor
13, 1113, 1143: Josephson junction device
15: square
20: readout port
30: filter
40: resonator
50, 1150: interconnect conductor
60, 1130: substrate
90, 1120: ground conductor
92: side surface
511: side surface
516, 526, 528: convex protrusion
517, 527, 529: concave recess
521: inner side surface
522: outer side surface

## Claims

1. A quantum device comprising:
one or more qubits, wherein:
each qubit of the one or more qubits includes:
a first conductor;
a second conductor surrounding the first conductor in a plan view; and
a Josephson junction device connected between the first conductor and the second conductor,
the first conductor has a first surface facing the second conductor,
the second conductor has a second surface facing the first conductor, and
the first surface, or the second surface, or both the first and second surfaces have a shape including at least two points having mutually different curvatures in the plan view.

2. The quantum device as claimed in claim 1, wherein the first surface, or the second surface, or both the first and second surfaces in the plan view include:
a convex protrusion that protrudes in a direction away from a center of gravity of the first conductor; and
a concave recess that is recessed in a direction toward the center of gravity.

3. The quantum device as claimed in claim 1 or 2, wherein both the first and second surfaces have the shape including at least two points having mutually different curvatures in the plan view.

4. The quantum device as claimed in claim 2, wherein, in a polar coordinate system having the center of gravity as an origin in the plan view, a sign of a rate of change in curvature of the first surface and a sign of a rate of change in curvature of the second surface at identical deflection angles match each other.

5. The quantum device as claimed in claim 4, wherein the first surface and the second surface are parallel to each other.

6. The quantum device as claimed in claim 4 or 5, wherein the shape of the first surface and the shape of the second surface are fourfold rotationally symmetric in the plan view.

7. The quantum device as claimed in claim 1 or 2, wherein two qubits of the one or more qubits are capacitively coupled to each other.

8. The quantum device as claimed in claim 1 or 2, further comprising:
a plurality of resonators capacitively coupled to a plurality of qubits of the one or more qubits, respectively;
a filter coupled to the plurality of resonators; and
a port capacitively coupled to the filter.

9. The quantum device as claimed in claim 1 or 2, further comprising:
a ground conductor provided in a periphery of the second conductor and having a ground potential, wherein:
the second conductor has a third surface facing the ground conductor,
the ground conductor has a fourth surface facing the second conductor, and
the third surface and the fourth surface are not parallel to each other.
